# EUROPEAN PATENT APPLICATION

(11) **EP 2 608 266 A2**
(43) Date of publication of application: **26.06.2013**
(21) Application number: 12198059.3
(22) Date of filing: 19.12.2012
(51) Int. Cl.: H01L 29/739, H01L 29/02, H01L 29/10

(54) **Semiconductor device having a gate electrode**

(30) Priority: 22.12.2011 JP 2011282024; 13.12.2012 JP 2012272122
(71) Applicant: NGK Insulators, Ltd., Nagoya-city, Aichi 467-8530 (JP)
(72) Inventor: Yokoi, Shoji, Nagoya city Aichi 467-8530 (JP); Shimizu, Naohiro, Nagoya city Aichi 467-8530 (JP); Kimura, Masakazu, Hamamatsu-city Shizuoka 432-8561 (JP)
(74) Representative: Naylor, Matthew John

(57) **Abstract**

A semiconductor device contains a first conductive type semiconductor substrate (12), at least one cathode (20) formed on one surface (12a) of the semiconductor substrate (12), an anode (22) formed on the other surface (12b) of the semiconductor substrate (12), and a gate electrode (24) electrically insulated from the cathode (20), formed on the one surface (12a) of the semiconductor substrate (12) to control current conduction between the cathode (20) and the anode (22). The semiconductor substrate (12) has a thickness (tb) of less than 460 µm.

## Description

### CROSS-REFERENCE TO RELATED APPLICATION

This application is based upon and claims the benefit of priority from Japanese Patent Applications No. 2011-282024 filed on December 22, 2011 and No. 2012-272122 filed on December 13, 2012, the contents all of which are incorporated herein by reference.

### BACKGROUND OF THE INVENTION

### Field of the Invention:

The present invention relates to a semiconductor device containing an anode formed on one surface of a semiconductor part and a plurality of cathode segments formed on the other surface of the semiconductor part, suitable for use in a static induction thyristor, a GTO thyristor, etc. Description of the Related Art:

In static induction thyristors, GTO thyristors, and the like, in general, an anode is formed on a back surface of a silicon substrate, and a large number of cathode segments are disposed on a front surface of the silicon substrate. A gate region is disposed around the cathode segments, and a gate electrode wiring is formed on the gate region (see Japanese Laid-Open Patent Publication Nos. 2001-119014, H09-008280, and 2000-058814).

### SUMMARY OF THE INVENTION

An object of the present invention is to provide a semiconductor device capable of exhibiting a reduced effective chip area and a reduced turn-off loss (an improved turn-off efficiency) while preventing turn-on loss increase (turn-on efficiency deterioration) due to the effective chip area reduction in the above static induction thyristors, GTO thyristors, and the like.
[1] According to a first aspect of the present invention, there is provided a semiconductor device containing a first conductive type semiconductor substrate, at least one cathode formed on one surface of the semiconductor substrate, an anode formed on the other surface of the semiconductor substrate, and a gate electrode formed on the one surface of the semiconductor substrate to control current conduction between the cathode and the anode, the gate electrode being electrically insulated from the cathode, wherein the semiconductor substrate has a thickness of less than 460 µm.
[2] In the first aspect, the semiconductor substrate preferably has a thickness of 440 µm or less.
[3] In the first aspect, the semiconductor substrate preferably has a thickness of 260 to 440 µm.
[4] In the first aspect, the semiconductor substrate preferably has a thickness of 300 to 430 µm.
[5] In the first aspect, the semiconductor substrate preferably has a thickness of 360 to 410 µm.
[6] In the first aspect, a first conductive type cathode segment may be disposed in a portion corresponding to at least the cathode in the one surface of the semiconductor substrate, and a second conductive type anode segment may be disposed in a portion corresponding to the anode in the other surface of the semiconductor substrate.
[7] In [6], a plurality of second conductive type embedded segments electrically connected to the gate electrode may be sandwiched between the cathode segment and the anode segment in the semiconductor substrate, and a first conductive type channel segment may be disposed between the embedded segments adjacent to each other.
[8] In [6] or [7], the anode segment preferably has a thickness of less than 1.5 µm.
[9] In [8], the anode segment preferably has a thickness of 0.02 to 1.0 µm.
[10] In [9], the anode segment preferably has a thickness of 0.05 to 0.5 µm.
[11] In [10], the anode segment preferably has a thickness of 0.1 to 0.2 µm.
[12] According to a second aspect of the present invention, there is provided a semiconductor device containing a first conductive type semiconductor substrate, at least one cathode formed on one surface of the semiconductor substrate, an anode formed on the other surface of the semiconductor substrate, and a gate electrode formed on the one surface of the semiconductor substrate to control current conduction between the cathode and the anode, the gate electrode being electrically insulated from the cathode, wherein a first conductive type cathode segment is disposed in a portion corresponding to the cathode in the one surface of the semiconductor substrate, a second conductive type anode segment is disposed in a portion corresponding to the anode in the other surface of the semiconductor substrate, the semiconductor substrate has a thickness of less than 460 µm, and the anode segment has a thickness of less than 1.5 µm.

By using the semiconductor device of the present invention in the static induction thyristors, GTO thyristors, and the like, the effective chip area can be reduced and the turn-off loss can be reduced (the turn-off efficiency can be improved) while the turn-on loss increase (the turn-on efficiency deterioration) due to the effective chip area reduction can be prevented.

The above and other objects, features, and advantages of the present invention will become more apparent from the following description when taken in conjunction with the accompanying drawings in which a preferred embodiment of the present invention is shown by way of illustrative example.

### BRIEF DESCRIPTION OF THE DRAWINGS

FIG. 1 is a top view of a semiconductor device according to an embodiment of the present invention;
FIG. 2A is a cross-sectional view taken along the line II-II in FIG. 1;
FIG. 2B is a transparent perspective view of the section;
FIG. 3A is a cross-sectional view taken along the line III-III in FIG. 1;
FIG. 3B is a transparent perspective view of the section (an insulating layer is not shown);
FIG. 4A is a cross-sectional view taken along the line IV-IV in FIG. 1;
FIG. 4B is a transparent perspective view of the section (an insulating layer is not shown); and
FIG. 5 is a circuit diagram of a high-voltage pulse generating circuit to which the semiconductor device is connected.

### DESCRIPTION OF THE PREFERRED EMBODIMENTS

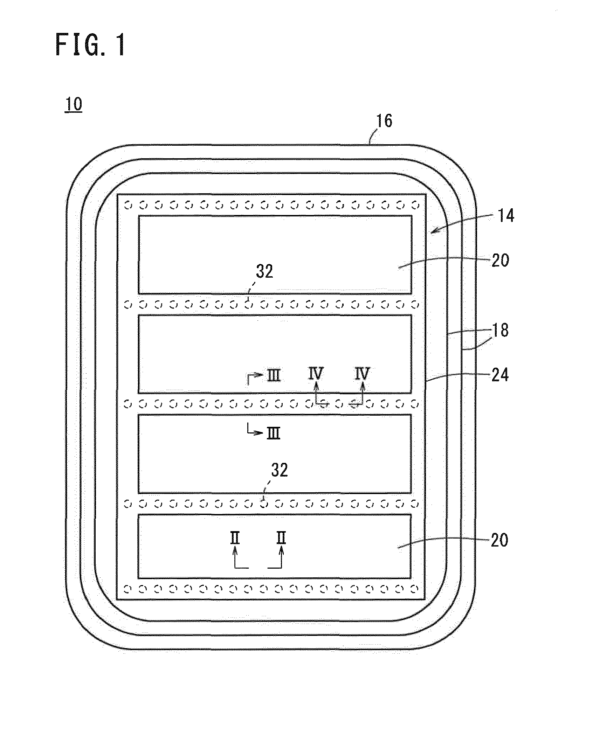

An embodiment of the semiconductor device of the present invention, usable in a normally-off embedded gate-type static induction thyristor or the like, will be described below with reference to FIGS. 1 to 5. It should be noted that, in this description, a numeric range of "A to B" includes both the numeric values A and B as the lower limit and upper limit values.

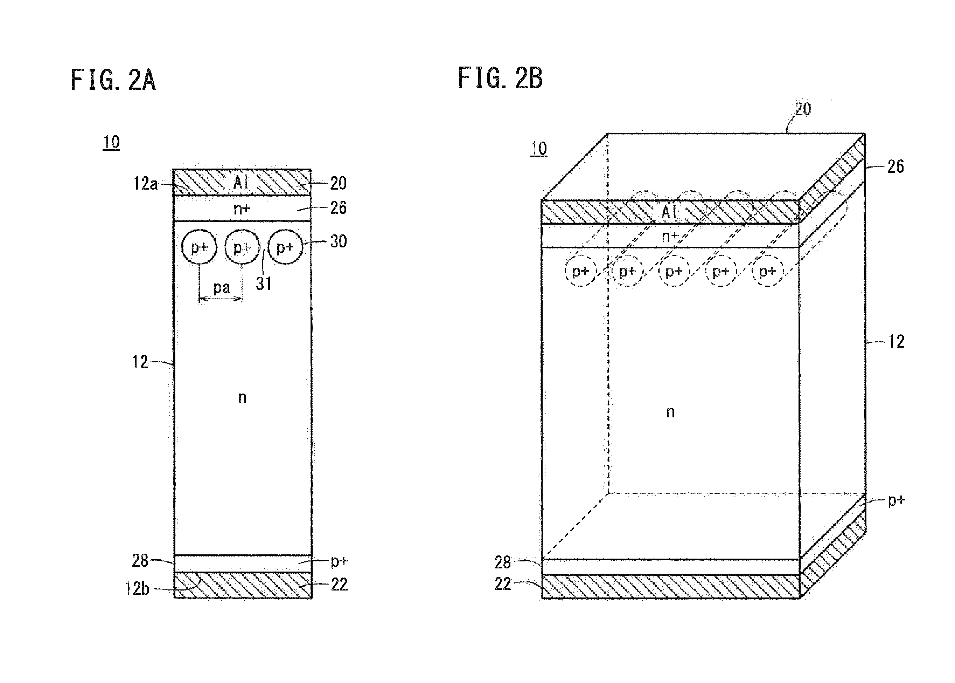

As shown in FIG. 1, a semiconductor device 10 according to this embodiment contains a first conductive type semiconductor substrate 12 (see, e.g., FIGS. 2A and 2B), has an approximately track-like top surface appearance, has an approximately rectangular element region 14 at the center, and has a channel stop region 16 located on the outermost periphery. Further, the semiconductor device 10 has a field limiting region 18 located around the element region 14, i.e. between the element region 14 and the channel stop region 16.

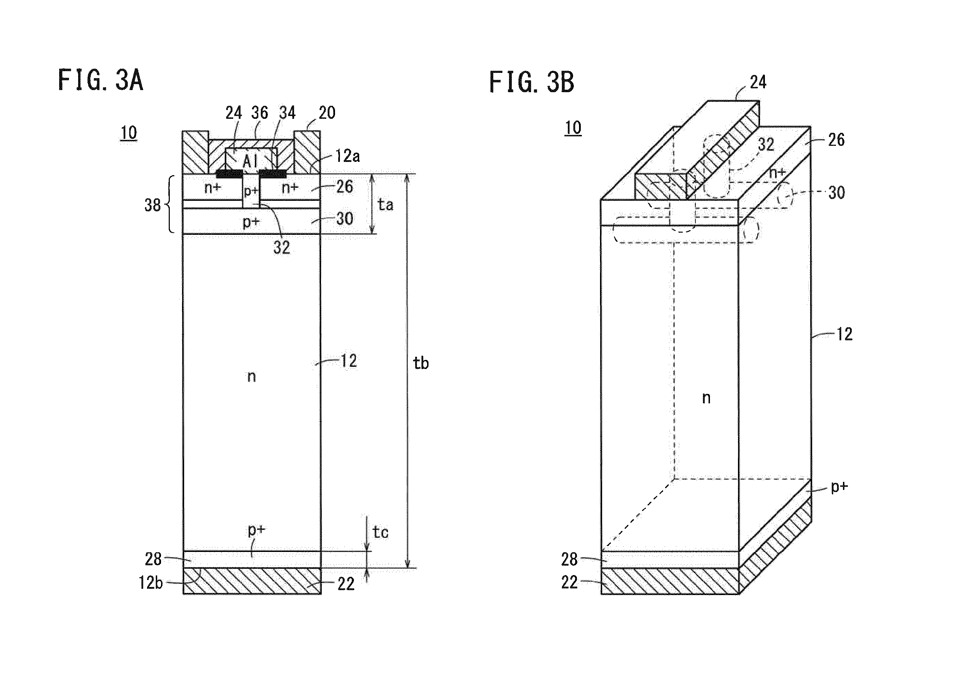

The element region 14 will be mainly described below. As shown in FIGS. 2A and 2B, the semiconductor device 10 contains the first conductive type semiconductor substrate 12, one or more cathodes 20 (e.g. containing a metal) formed on one surface 12a of the semiconductor substrate 12, at least one anode 22 (e.g. containing a metal) formed on the other surface 12b of the semiconductor substrate 12, and a gate electrode 24 (e.g. containing a metal) formed on the one surface 12a of the semiconductor substrate 12 as shown in FIG. 3A to control current conduction between the cathodes 20 and the anode 22, the gate electrode 24 being electrically insulated from the cathodes 20. In the example of FIG. 1, the semiconductor device 10 contains four cathodes 20 surrounded by the gate electrode 24. Thus, the gate electrode 24 extends between the adjacent cathodes 20 and between each cathode 20 and the field limiting region 18. Though only two lines are shown in the field limiting region 18 in FIG. 1, five to twenty lines are practically formed in the field limiting region 18.

Furthermore, as shown in FIGS. 2A and 2B, in the semiconductor device 10, first conductive type cathode segments 26 are disposed in portions corresponding to at least the cathodes 20 in the one surface 12a of the semiconductor substrate 12, and a second conductive type anode segment 28 disposed in a portion corresponding to the anode 22 in the other surface 12b of the semiconductor substrate 12.

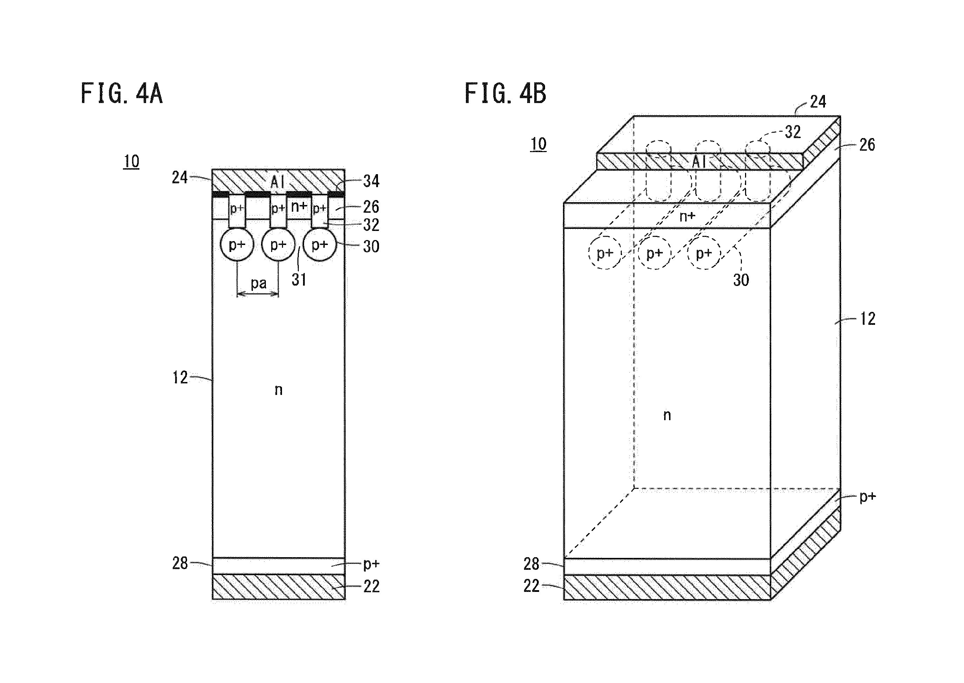

In addition, as shown in FIGS. 3A, 3B, 4A, and 4B, a plurality of second conductive type embedded segments 30 are sandwiched between the cathode segments 26 and the anode segment 28 in the semiconductor substrate 12. The embedded segments 30 are disposed in portions closer to the cathode segments 26 than to the anode segment 28, and are electrically connected to the gate electrode 24. The embedded segments 30 are at an approximately constant arrangement pitch Pa (see FIG. 4A). First conductive type channel segments 31 are disposed between the adjacent embedded segments 30. The embedded segments 30 and the gate electrode 24 are electrically connected by second conductive type takeoff segments 32 disposed between the embedded segments 30 and the gate electrode 24. First insulating layers 34 are interposed between the gate electrode 24 and the cathode segments 26, and second insulating layers 36 are interposed between the gate electrode 24 and the cathodes 20.

In this embodiment, the semiconductor device 10 has an epitaxial layer 38 formed by an epitaxial growth process. The epitaxial layer 38 includes the embedded segments 30, the cathode segments 26, and the takeoff segments 32, and further includes first conductive type segments between the embedded segments 30 and the cathode segments 26. In this case, the thickness ta of the epitaxial layer 38 is 0.5 to 13 µm. In this embodiment, the thickness ta is preferably 0.5 to 10 µm, more preferably 1 to 10 µm, further preferably 1 to 5 µm, particularly preferably 1 to 2 µm. For example, when the thickness ta of the epitaxial layer 38 is 13 µm, the arrangement pitch Pa of the embedded segments 30 is 23 µm. In contrast, when the thickness ta of the epitaxial layer 38 is 2 µm, the arrangement pitch Pa of the embedded segments 30 is 12 µm, which is advantageous for reducing the chip area of the semiconductor device 10. When the epitaxial layer 38 has a smaller thickness ta, the one surface 12a of the semiconductor substrate 12 (the upper surface of the epitaxial layer 38) can be a substantially flat surface free from mesa portions, and the cathodes 20 can be formed closer to the gate electrode 24. Therefore, such a smaller thickness ta is advantageous for reducing the chip area of the semiconductor device 10. Furthermore, in this embodiment, since the metal gate electrode 24 extends on a large number of the takeoff segments 32 and is electrically connected to a plurality of the embedded segments 30 by the takeoff segments 32, the gate electrode 24 per se can be utilized for forming a shunt structure of the embedded segments 30, and a control signal can be rapidly sent to the embedded segments 30. This leads to improvement in the switching speed of the semiconductor device 10.

Materials of the components may be as follows. For example, the semiconductor substrate 12 is an n-type silicon substrate having an impurity concentration of 10¹³ (cm⁻³) order, the cathode segment 26 is an n⁺ impurity region having an impurity concentration of 10¹⁹ (cm⁻³) order, the anode segment 28, each embedded segment 30, and each takeoff segment 32 are a p⁺ impurity region having an impurity concentration of 10¹⁹ (cm⁻³) order, the first insulating layer 34 is an SiO₂ film, the second insulating layer 36 is an SiNₓ film, a polyimide film, or a silicone film, and the cathode 20, the anode 22, and each gate electrode 24 contain aluminum (Al).

The thickness tb of the semiconductor substrate 12 (see FIG. 3A) is less than 460 µm. In this embodiment, the thickness tb is preferably 440 µm or less, more preferably 260 to 440 µm, further preferably 300 to 430 µm, particularly preferably 360 to 410 µm. As long as the thickness tb of the semiconductor substrate 12 is controlled within the above-mentioned range, the on voltage can be lowered to reduce the turn-on loss, though the turn-off leakage current is not reduced. Therefore, the semiconductor device 10 can act to improve the turn-on efficiency in a practical circuit. In view of improving the device efficiency, the turn-on loss reduction has priority over the turn-off loss reduction. Thus, the device efficiency can be improved by controlling the thickness tb of the semiconductor substrate 12 within the above range.

The thickness tc of the anode segment 28 is less than 1.5 µm. In this embodiment, the thickness tc is preferably 0.02 to 1.0 µm, further preferably 0.05 to 0.5 µm, particularly preferably 0.1 to 0.2 µm. When the thickness tc of the anode segment 28 is within the above-mentioned range, the turn-off leakage current can be reduced to reduce the turn-off loss, though the on voltage is not lowered. Therefore, the semiconductor device 10 can act to improve the turn-off efficiency in a practical circuit.

Particularly in this embodiment, since the thickness tb of the semiconductor substrate 12 is less than 460 µm and the thickness tc of the anode segment 28 is less than 1.5 µm, both the turn-on and turn-off losses can be reduced. Consequently, the semiconductor device 10 can act to improve both the turn-on and turn-off efficiencies in a practical circuit.

Evaluation of the turn-on and turn-off efficiencies of a practical circuit using the semiconductor device 10 of this embodiment will be described below.

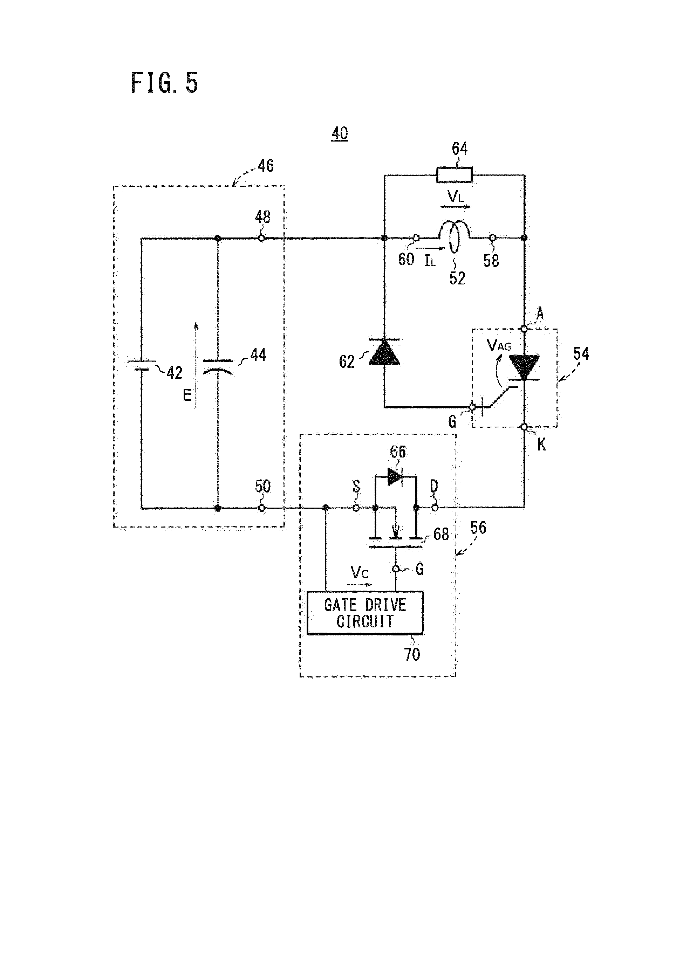

As shown in FIG. 5, the turn-on and turn-off efficiencies are evaluated using a high-voltage pulse generating circuit shown in FIG. 1 of Japanese Laid-Open Patent Publication No. 2004-072994.

As shown in FIG. 5, in the high-voltage pulse generating circuit 40, a direct-current power source unit 46 contains a direct-current power source 42 and a capacitor 44 for reducing the high-frequency impedance. A coil 52, a first semiconductor switch 54, and a second semiconductor switch 56 are series-connected to both ends 48, 50 of the direct-current power source unit 46. One end 58 of the coil 52 is connected to an anode terminal A of the first semiconductor switch 54. A diode 62 is interposed between the other end 60 of the coil 52 and a control terminal (gate terminal) G of the first semiconductor switch 54 such that the anode is connected to the control terminal G. A load 64 requiring a high-voltage pulse is connected in parallel with the coil 52. The second semiconductor switch 56 contains a power metal-oxide semiconductor field-effect transistor 68 (hereinafter referred to as the power MOSFET 68) and a gate drive circuit 70. The power MOSFET 68 is equipped with an inverse-parallel-connected avalanche diode 66. The gate drive circuit 70 is connected to a gate terminal G and a source terminal S of the power MOSFET 68 to control the on and off states of the power MOSFET 68.

In the high-voltage pulse generating circuit 40, the semiconductor device 10 of this embodiment is connected as the first semiconductor switch 54, and a capacitor is connected as the load 64. An electric power is supplied to the high-voltage pulse generating circuit 40, and the semiconductor device 10 is turned on. After the elapse of a predetermined charging time, the semiconductor device 10 is turned off, and a high voltage V_{L} is generated at both ends of the load.

The turn-on efficiency is a ratio of an energy stored in the coil 52. The energy ratio is calculated from a current I_{L}, which flows through the coil 52 when the semiconductor device 10 is turned on. Thus, as the on voltage is lowered (the turn-on loss is reduced), the energy stored in the coil 52 is increased to improve the turn-on efficiency. On the contrary, as the on voltage is increased (the turn-on loss is increased), the energy stored in the coil 52 is reduced to lower the turn-on efficiency.

The turn-off efficiency is a maximum ratio, at which the energy stored in the coil 52 can be converted to an energy stored in the capacitor (load). The maximum ratio is calculated from a highest voltage (highest generated voltage) V_{L}, which is generated between both ends of the load 64 when the semiconductor device 10 is turned off. Thus, as the turn-off leakage current is reduced (the turn-off loss is reduced), the highest generated voltage V_{L} is increased, so that the ratio of the conversion to the energy stored in the capacitor is increased, resulting in improvement of the turn-off efficiency. On the contrary, as the turn-off leakage current is increased (the turn-off loss is increased), the highest generated voltage V_{L} is lowered, so that the ratio of the conversion to the energy stored in the capacitor is reduced to lower the turn-off efficiency.

### [First Example]

In First Example, the semiconductor devices 10 of Examples 1 to 6 and Reference Example 1, which had various thicknesses tb of the semiconductor substrates 12, were evaluated with respect to the turn-on and turn-off efficiencies.

### (Example 1)

The semiconductor device of Example 1 was produced such that the thickness tb of the semiconductor substrate 12 was 440 µm, the thickness ta of the epitaxial layer 38 was 13 µm, and the thickness tc of the anode segment 28 was 1.5 µm in the semiconductor device 10 shown in FIGS. 1 to 4B.

### (Examples 2 to 6)

The semiconductor devices of Examples 2, 3, 4, 5, and 6 were produced in the same manner as Example 1 except that the thicknesses tb of the semiconductor substrates 12 were 430, 410, 360, 300, and 260 µm, respectively.

### (Reference Example 1)

The semiconductor device of Reference Example 1 was produced in the same manner as Example 1 except that the thickness tb of the semiconductor substrate 12 was 200 µm.

### (Evaluation: turn-on and turn-off efficiencies)

The turn-on and turn-off efficiencies were evaluated using the high-voltage pulse generating circuit 40 shown in FIG. 5 (the high-voltage pulse generating circuit shown in FIG. 1 of Japanese Laid-Open Patent Publication No. 2004-072994) as described above. In the high-voltage pulse generating circuit 40, the semiconductor device 10 was connected as the first semiconductor switch 54, and the capacitor was connected as the load 64. The electric power was supplied to the high-voltage pulse generating circuit 40, and the semiconductor device 10 was turned on. After the elapse of the predetermined charging time (4 µs), the semiconductor device 10 was turned off, and the high voltage was generated at both ends of the load.

The turn-on efficiency was evaluated in terms of the ratio of the energy stored in the coil 52. The energy ratio was calculated from the current, which flowed through the coil 52 when the semiconductor device 10 was turned on. Specifically, the energy ratio was obtained using the expression of (I/Io)×100 (%), in which Io (A) represented a current obtained in an optimum structure, and I (A) represented a current that practically flowed through the coil 52 when the semiconductor device 10 was turned on.

The turn-off efficiency was evaluated in terms of the maximum ratio, at which the energy stored in the coil 52 could be converted to the energy stored in the capacitor. Specifically, the maximum ratio was obtained using the expression of (V/Vo)×100 (%), in which Vo (V) represented a highest generated voltage obtained in an optimum structure, and V (V) represented a highest voltage (highest generated voltage) practically generated between both ends of the load when the semiconductor device 10 was turned off.

The evaluation results are shown in Table 1.

**Table 1**

| | Semiconductor substrate thickness (µm) | Turn-on efficiency (%) | Turn-off efficiency (%) |
|---|---|---|---|
| Example 1 | 440 | 83 | 76 |
| Example 2 | 430 | 84 | 72 |
| Example 3 | 410 | 85 | 68 |
| Example 4 | 360 | 89 | 58 |
| Example 5 | 300 | 91 | 43 |
| Example 6 | 260 | 94 | 33 |
| Reference Example 1 | 200 | 97 | 21 |

As shown in Table 1, in Examples 1 to 6, the turn-on efficiencies were at least 83% to achieve high device efficiencies. As the thickness tb of the semiconductor substrate 12 was reduced, the turn-off efficiency was lowered. However, even in Example 6, the turn-off efficiency was 33%, which was at a practical level (30% or more). In Reference Example 1, the turn-on efficiency was a high value of 97%, while the turn-off efficiency was 21% below the practical level.

Consequently, the thickness tb of the semiconductor substrate 12 was desirably less than 460 µm, preferably 440 µm or less, more preferably 260 to 440 µm, further preferably 300 to 430 µm, particularly preferably 360 to 410 µm.

### [Second Example]

In Second Example, the semiconductor devices 10 of Examples 7 to 12, which had various thicknesses tc of the anode segments 28, were evaluated with respect to the turn-on and turn-off efficiencies.

### (Example 7)

The semiconductor device of Example 7 was produced such that the thickness tb of the semiconductor substrate 12 was 460 µm, the thickness ta of the epitaxial layer 38 was 13 µm, and the thickness tc of the anode segment 28 was 1.0 µm in the semiconductor device 10 shown in FIGS. 1 to 4B.

### (Examples 8 to 12)

The semiconductor devices of Examples 8, 9, 10, 11, and 12 were produced in the same manner as Example 7 except that the thicknesses tc of the anode segments 28 were 0.5, 0.2, 0.1, 0.05, and 0.02 µm, respectively.

### (Evaluation: turn-on and turn-off efficiencies)

The turn-on and turn-off efficiencies were evaluated in the same manner as First Example, and the duplicate explanations thereof are omitted.

The evaluation results are shown in Table 2.

**Table 2**

| | Anode segment thickness (µm) | Turn-on efficiency (%) | Turn-off efficiency (%) |
|---|---|---|---|
| Example 7 | 1.0 | 82 | 81 |
| Example 8 | 0.5 | 81 | 81 |
| Example 9 | 0.2 | 79 | 82 |
| Example 10 | 0.1 | 79 | 82 |
| Example 11 | 0.05 | 78 | 82 |
| Example 12 | 0.02 | 77 | 83 |

As shown in Table 2, in Examples 7 to 12, the turn-off efficiencies were at least 81%. As the thickness tc of the anode segment 28 was reduced, the turn-on efficiency was lowered. However, even in Example 12, the turn-on efficiency was 77%, which was at a practical level (70% or more).

Consequently, the thickness tc of the anode segment 28 was desirably less than 1.5 µm, preferably 0.02 to 1.0 µm, further preferably 0.05 to 0.5 µm, particularly preferably 0.1 to 0.2 µm.

### [Third Example]

In Third Example, the semiconductor devices 10 of Examples 21 to 38, which had various thicknesses tb of the semiconductor substrates 12 and various thicknesses tc of the anode segments 28, were evaluated with respect to the turn-on and turn-off efficiencies.

### (Example 21)

The semiconductor device of Example 21 was such that the thickness tb of the semiconductor substrate 12 was 440 µm, the thickness ta of the epitaxial layer 38 was 13 µm, and the thickness tc of the anode segment 28 was 0.2 µm in the semiconductor device 10 shown in FIGS. 1 to 4B.

### (Examples 22 and 23)

The semiconductor devices of Examples 22 and 23 were produced in the same manner as Example 21 except that the thicknesses tc of the anode segments 28 were 0.1 and 0.05 µm, respectively.

### (Example 24)

The semiconductor device of Example 24 was produced in the same manner as Example 21 except that the thickness tb of the semiconductor substrate 12 was 430 µm.

### (Examples 25 and 26)

The semiconductor devices of Examples 25 and 26 were produced in the same manner as Example 24 except that the thicknesses tc of the anode segments 28 were 0.1 and 0.05 µm, respectively.

### (Example 27)

The semiconductor device of Example 27 was produced in the same manner as Example 21 except that the thickness tb of the semiconductor substrate 12 was 410 µm.

### (Examples 28 and 29)

The semiconductor devices of Examples 28 and 29 were produced in the same manner as Example 27 except that the thicknesses tc of the anode segments 28 were 0.1 and 0.05 µm, respectively.

### (Example 30)

The semiconductor device of Example 30 was produced in the same manner as Example 21 except that the thickness tb of the semiconductor substrate 12 was 360 µm.

### (Examples 31 and 32)

The semiconductor devices of Examples 31 and 32 were produced in the same manner as Example 30 except that the thicknesses tc of the anode segments 28 were 0.1 and 0.05 µm, respectively.

### (Example 33)

The semiconductor device of Example 33 was produced in the same manner as Example 21 except that the thickness tb of the semiconductor substrate 12 was 300 µm.

### (Examples 34 and 35)

The semiconductor devices of Examples 34 and 35 were produced in the same manner as Example 33 except that the thicknesses tc of the anode segments 28 were 0.1 and 0.05 µm, respectively.

### (Example 36)

The semiconductor device of Example 36 was produced in the same manner as Example 21 except that the thickness tb of the semiconductor substrate 12 was 260 µm.

### (Examples 37 and 38)

The semiconductor devices of Examples 37 and 38 were produced in the same manner as Example 36 except that the thicknesses tc of the anode segments 28 were 0.1 and 0.05 µm, respectively.

### (Evaluation: turn-on and turn-off efficiencies)

The turn-on and turn-off efficiencies were evaluated in the same manner as First Example, and the duplicate explanations thereof are omitted.

The evaluation results are shown in Table 3.

**Table 3**

| | Semiconductor substrate thickness (µm) | Anode segment thickness (µm) | Turn-on efficiency (%) | Turn-off efficiency (%) |
|---|---|---|---|---|
| Example 21 | 440 | 0.2 | 81 | 79 |
| Example 22 | 440 | 0.1 | 81 | 79 |
| Example 23 | 440 | 0.05 | 81 | 79 |
| Example 24 | 430 | 0.2 | 82 | 77 |
| Example 25 | 430 | 0.1 | 82 | 77 |
| Example 26 | 430 | 0.05 | 82 | 77 |
| Example 27 | 410 | 0.2 | 82 | 75 |
| Example 28 | 410 | 0.1 | 82 | 75 |
| Example 29 | 410 | 0.05 | 82 | 75 |
| Example 30 | 360 | 0.2 | 84 | 70 |
| Example 31 | 360 | 0.1 | 84 | 70 |
| Example 32 | 360 | 0.05 | 84 | 70 |
| Example 33 | 300 | 0.2 | 85 | 63 |
| Example 34 | 300 | 0.1 | 85 | 63 |
| Example 35 | 300 | 0.05 | 84 | 63 |
| Example 36 | 260 | 0.2 | 87 | 58 |
| Example 37 | 260 | 0.1 | 86 | 58 |
| Example 38 | 260 | 0.05 | 86 | 58 |

As shown in Table 3, in Examples 21 to 38, the turn-on efficiencies were at least 81%, resulting in high device efficiencies. As the thickness tb of the semiconductor substrate 12 was reduced, the turn-off efficiency was lowered. In Example 6 (in which the thickness tb of the semiconductor substrate 12 was 260 µm), the turn-off efficiency was only 33%. In contrast, in Examples 36 to 38, though the thickness tb of the semiconductor substrate 12 was 260 µm, the turn-off efficiency was increased to 58%. It was considered that the increase was achieved by reducing the thickness tc of the anode segment 28.

## Claims

1. A semiconductor device comprising
a first conductive type semiconductor substrate (12),
at least one cathode (20) formed on one surface (12a) of the semiconductor substrate (12),
an anode (22) formed on the other surface (12b) of the semiconductor substrate (12), and
a gate electrode (24) formed on the one surface (12a) of the semiconductor substrate (12) to control current conduction between the cathode (20) and the anode (22),
the gate electrode (24) being electrically insulated from the cathode (20),
wherein the semiconductor substrate (12) has a thickness (tb) of less than 460 µm.

2. The semiconductor device according to claim 1,
wherein the semiconductor substrate (12) has a thickness (tb) of 440 µm or less.

3. The semiconductor device according to claim 2,
wherein the semiconductor substrate (12) has a thickness (tb) of 260 to 440 µm.

4. The semiconductor device according to claim 3,
wherein the semiconductor substrate (12) has a thickness (tb) of 300 to 430 µm.

5. The semiconductor device according to claim 4,
wherein the semiconductor substrate (12) has a thickness (tb) of 360 to 410 µm.

6. The semiconductor device according to claim 1,
wherein a first conductive type cathode segment (26) is disposed in a portion corresponding to at least the cathode (20) in the one surface (12a) of the semiconductor substrate (12), and
a second conductive type anode segment (28) is disposed in a portion corresponding to the anode (22) in the other surface (12b) of the semiconductor substrate (12).

7. The semiconductor device according to claim 6,
wherein a plurality of second conductive type embedded segments (30) electrically connected to the gate electrode (24) are sandwiched between the cathode segment (26) and the anode segment (28) in the semiconductor substrate (12), and
a first conductive type channel segment (31) is disposed between the embedded segments (30) adjacent to each other.

8. The semiconductor device according to claim 6,
wherein the anode segment (28) has a thickness (tc) of less than 1.5 µm.

9. The semiconductor device according to claim 8,
wherein the anode segment (28) has a thickness (tc) of 0.02 to 1.0 µm.

10. The semiconductor device according to claim 9,
wherein the anode segment (28) has a thickness (tc) of 0.05 to 0.5 µm.

11. The semiconductor device according to claim 10,
wherein the anode segment (28) has a thickness (tc) of 0.1 to 0.2 µm.

12. A semiconductor device comprising
a first conductive type semiconductor substrate (12),
at least one cathode (20) formed on one surface (12a) of the semiconductor substrate (12),
an anode (22) formed on the other surface (12b) of the semiconductor substrate (12), and
a gate electrode (24) formed on the one surface (12a) of the semiconductor substrate (12) to control current conduction between the cathode (20) and the anode (22),
the gate electrode (24) being electrically insulated from the cathode (20),
wherein a first conductive type cathode segment (26) is disposed in a portion corresponding to the cathode (20) in the one surface (12a) of the semiconductor substrate (12),
a second conductive type anode segment (28) is disposed in a portion corresponding to the anode (22) in the other surface (12b) of the semiconductor substrate (12),
the semiconductor substrate (12) has a thickness (tb) of less than 460 µm, and
the anode segment (28) has a thickness (tc) of less than 1.5 µm.
